# FASCICULE DE BREVET EUROPEEN

(11) **EP 2 383 856 B1**
(45) Date de publication et mention de la délivrance du brevet: **27.06.2018**
(21) Numéro de dépôt: 11354008.2
(22) Date de dépôt: 22.03.2011
(51) Int. Cl.: H02H 3/347, G01R 31/08

(54) **IDENTIFICATION ET DÉTECTION DIRECTIONNELLE D'UN DÉFAUT DANS UN RESEAU TRIPHASE**
IDENTIFIZIERUNG UND RICHTUNGSERFASSUNG EINES DEFEKTS IN EINEM DREIPHASENNETZ
IDENTIFICATION AND DIRECTIONAL DETECTION OF A DEFECT IN A THREE-PHASE NETWORK

(30) Priorité: 30.04.2010 FR 1001847
(43) Date de publication de la demande: 02.11.2011
(73) Titulaire: Schneider Electric Industries SAS, 92500 Rueil-Malmaison (FR)
(72) Inventeur: Cumunel, Pascal, 38050 Grénoble Cedex 09 (FR); Verneau, Guillaume, 38050 Grenoble Cedex 09 (FR)
(74) Mandataire: Colette, Marie-Françoise

(56) Documents cités:
- EP-A1- 1 475 874
- JP-A- 10 004 623
- JP-A- 2003 102 125
- US-A- 4 423 374

## Description

### DOMAINE TECHNIQUE

L'invention concerne l'identification et la détection directionnelle d'un défaut entre deux phases d'un réseau triphasé sans mesure de tension de la ligne. En particulier, l'invention est relative à un procédé de détection d'un défaut biphasé dans un réseau permettant en outre de déterminer si le défaut est localisé en amont ou en aval du point de détection. Le procédé selon l'invention repose sur les seuls signaux représentatifs des courants de chaque phase du réseau, dont le traitement résulte en paramètres permettant la localisation directionnelle. Le procédé de détection directionnelle du défaut biphasé peut être couplé à d'autres étapes pour identifier et localiser un défaut monophasé ou triphasé.

Sous un autre aspect, l'invention concerne un dispositif de détection apte à mettre en oeuvre le procédé précédent. En particulier, le dispositif de détection directionnelle de défaut comprend des moyens permettant de calculer des paramètres à partir des signaux de courant de chaque phase, l'interprétation desdits paramètres donnant la nature et/ou la localisation relative du défaut sans utiliser de valeurs représentatives de la tension entre phases, ni de valeurs représentatives des tensions simples.

L'invention concerne enfin un dispositif de signalisation de défaut et un relai de déclenchement comprenant des capteurs de courant associés à chaque phase du réseau et fournissant au dispositif de détection précédent les signaux permettant la signalisation, par exemple par voyant, ou le déclenchement d'un dispositif de coupure du réseau.

### ETAT DE LA TECHNIQUE

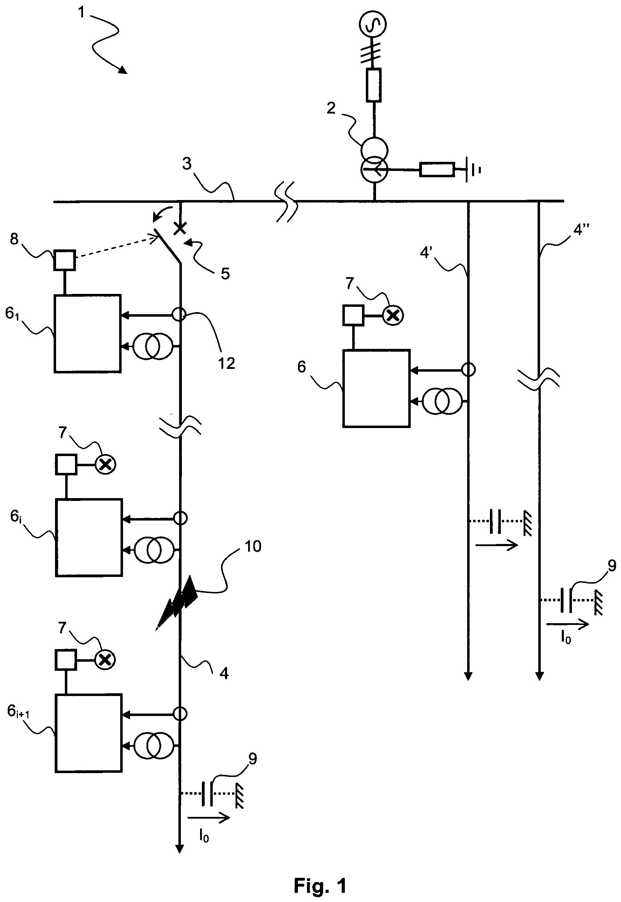

Les dispositifs de détection de défaut dans les réseaux triphasés permettent de déclencher la protection des charges et/ou d'aider à la localisation desdits défauts. Par exemple, la figure 1 représente un schéma d'un réseau 1 de distribution électrique moyenne tension qui comporte un transformateur 2 triphasé dont le secondaire est connecté à une ligne principale 3 de distribution ; le secondaire comporte par ailleurs un conducteur commun de neutre généralement connecté à la terre par une impédance. La ligne principale 3 alimente des lignes de départ 4, 4', 4", dont certaines peuvent comporter en tête un disjoncteur ou autre dispositif de coupure 5 les protégeant. Un dispositif de détection de défaut de type court-circuit 6 installé sur les lignes de départ 4', ou des tronçons de ligne 4, peut servir d'indicateur de passage de défaut, allumant par exemple un voyant lumineux 7 ; un dispositif 6₁ peut par ailleurs être associé ou intégré à un relai de protection 8 apte à commander l'ouverture des contacts du disjoncteur 5.

Entre les conducteurs de ligne 4 et la terre peuvent apparaître des fortes valeurs de capacité 9, à l'origine de la circulation d'importants courants homopolaires I₀ en cas de défaut à la terre 10 : pour éviter une fausse détection d'un dispositif 6ᵢ₊₁ de détection de défaut à la terre causée par une défaillance d'un départ voisin par liaison capacitive 9, des dispositifs et procédés ont été développés pour distinguer si un défaut à la terre 10 est localisé en aval du dispositif de détection 6ᵢ, ou en amont du dispositif 6ᵢ₊₁. En particulier, les documents US 4 423 374, EP 1 475 874, EP 1 890 165, FR 2 936 319, FR 2 936 378 ou WO 2006/136520 proposent des solutions utilisant, entre autres, la mesure des courants par des capteurs adaptés 12. Plusieurs phases peuvent être en défaut simultanément dans la ligne triphasée 3, 4, que ce soit un défaut triphasé, un défaut biphasé à la terre ou un défaut biphasé isolé. L'identification de la présence d'un défaut est basée sur la détection de surintensités dans au moins une phase du réseau 1, et ce sur une durée minimale de défaut. Pour préciser la nature du défaut et/ou sa position relative, une mesure de la tension de chaque phase, voire d'autres paramètres, doit également être réalisée.

Il apparaît ainsi que les dispositifs de détection de défaut existants ne sont pas optimisés pour une large mise en oeuvre en raison de leur complexité, notamment due au nombre de capteurs à mettre en place lorsqu'une localisation directionnelle est souhaitée. Par ailleurs, avec les dispositifs de détection les moins complexes et comprenant seulement des capteurs d'intensité 12, la distinction entre défauts biphasés et monophasés à la terre n'est pas garantie dans certaines applications, notamment selon le régime de neutre.

### EXPOSE DE L'INVENTION

Parmi autres avantages, l'invention vise à pallier des inconvénients des dispositifs et procédés de détection directionnelle de défaut, notamment biphasé, existants. En particulier, le principe mis en oeuvre repose sur l'analyse de la fréquence d'un signal représentatif du courant d'une ligne triphasé pour l'identification de la nature du défaut et sur l'analyse des amplitudes ou autres valeurs normées des courants de phase pour la localisation relative du défaut, sans utilisation des tensions réseau, et sans nécessité d'un échantillonnage important des signaux représentatifs desdits courants (typiquement, une fréquence d'échantillonnage inférieure à 1 kHz, par exemple de l'ordre de 600 Hz, suffit).

Plus généralement, l'identification de la nature biphasée d'un défaut repose selon l'invention sur l'analyse fréquentielle du courant somme des alternances de même polarité de chaque phase. Notamment, en présence d'un défaut, lorsque le rapport entre les composantes continue et d'harmonique deux du courant pseudo-homopolaire dépasse un/cinq, le défaut est considéré comme biphasé, ledit courant pseudo-homopolaire résultant de la somme vectorielle des courants de phase redressés mono-alternance. Dans le cas où le rapport est inférieur à 20 %, selon un mode de réalisation préféré, il est possible de déterminer si le défaut est monophasé ou triphasé en approfondissant l'analyse fréquentielle précédente et en comparant au même rapport un/cinq la composante continue et la composante de fréquence propre du réseau. Avantageusement, l'analyse fréquentielle précédente est complétée par des analyses des amplitudes ou autres valeurs normées des courants de phase, pour déterminer la position relative du défaut par rapport au point de mesure des courants de phase.

Sous un de ses aspects, l'invention est relative à un procédé d'identification et de détection directionnelle de défaut dans un réseau triphasé, comprenant un premier stade de détection du défaut, par exemple par vérification de l'évolution d'un signal représentatif du courant, notamment de l'amplitude du courant circulant dans chaque phase.

Si le premier stade détecte la présence d'un défaut dans ledit tronçon, le deuxième stade d'identification du défaut du procédé selon l'invention est déclenché. Le deuxième stade est basé sur l'analyse d'un paramètre représentatif du courant correspondant à la somme des alternances de même polarité des courants de phase. Une fois ce paramètre obtenu, une analyse fréquentielle permet de comparer la composante de fréquence double du réseau à la composante continue afin d'identifier la nature biphasée du défaut ; avantageusement, la comparaison avec la composante continue est également réalisée pour la composante à fréquence propre du réseau pour identifier les défauts monophasés ou triphasés.

Un troisième stade de localisation relative du défaut détecté peut être mis en oeuvre; il est basé sur le traitement des signaux représentatifs d'une norme des courants de chaque phase dudit tronçon, ces signaux étant obtenus sur une durée prédéterminée suffisante, par exemple un nombre entier de demi-périodes du réseau ; toute norme d'un courant alternatif convient pour la localisation relative selon l'invention mais, de façon préférée, la valeur efficace du courant ou son amplitude sont utilisées. Après l'acquisition des signaux représentatifs de la norme des courants de phase, le troisième stade du procédé se poursuit par un traitement desdits signaux pour permettre d'interpréter si le défaut détecté dans le premier stade se situe en amont ou en aval du point de mesure des courants de phase. Le traitement des signaux comprend selon l'invention le calcul de la moyenne des signaux représentatifs des normes des courants de phase, et la comparaison de la moyenne avec chacun des signaux : si une seule norme des courants de phase après l'occurrence du défaut monophasé (respectivement biphasé) est supérieure à la moyenne des normes calculées pour les trois phases, alors le défaut se situe en aval (respectivement en amont) de la détection.

Pour préciser la nature d'un défaut biphasé, le troisième stade peut être prolongé par un quatrième stade, dans lequel l'évolution globale des courants de phase est considérée, et notamment la norme représentative des courants de chaque phase est comparée avec la valeur qu'elle prenait avant le défaut. Suivant le nombre de phases qui ont vu leur norme augmenter et en fonction de la localisation relative précédemment définie, il est possible de distinguer un défaut biphasé à la terre d'un défaut biphasé isolé. Parallèlement, la localisation d'un défaut triphasé peut être réalisée par évaluation de la composante continue du courant homopolaire ou du courant correspondant au premier paramètre.

Avantageusement, les signaux représentatifs des courants de phases sont filtrés, notamment analogiquement, et/ou échantillonnés ; selon l'invention, il est possible d'utiliser une fréquence d'échantillonnage relativement faible, notamment inférieure à 1 kHz, par exemple de l'ordre de 500 Hz ou 600 Hz.

Selon un mode de réalisation préféré du procédé selon l'invention, ledit procédé de détection directionnelle est associé à un actionnement d'un dispositif de coupure pour isoler le tronçon à partir du point en aval duquel un défaut a été détecté.

Sous un autre aspect, l'invention se rapporte à un dispositif d'identification d'un défaut d'une ligne dans un réseau triphasé, éventuellement couplée à la détection directionnelle, adapté pour le procédé précédent. Le dispositif selon l'invention peut être associé à des capteurs comme des tores de détection qui lui fournissent les signaux représentatifs desdits courants. Le dispositif d'identification et/ou de détection directionnelle peut en outre faire partie d'un indicateur de passage de défaut, par exemple par activation de moyens d'alerte de type voyant si un défaut aval aux capteurs est détecté ; un autre signal, par exemple une couleur différente, peut par ailleurs également indiquer un défaut amont. Dans un mode de réalisation particulièrement préféré, le dispositif de détection directionnelle selon l'invention est associé à un relai de protection de la ligne, les moyens d'alerte provoquant l'actionnement d'un dispositif de coupure de la ligne permettant d'isoler le tronçon sur lequel un défaut a été détecté.

En particulier, le dispositif d'identification selon l'invention comprend des premiers moyens pour fournir un premier paramètre représentatif du courant de chaque phase de la ligne à surveiller, à savoir la somme des alternances de même polarité du courant, ou courant « pseudo-homopolaire ». Pour la détection directionnelle, les premiers moyens sont adaptés pour fournir également un deuxième paramètre représentatif d'une norme du courant de chaque phase de la ligne à surveiller. Avantageusement, les premiers moyens sont associés à des moyens de filtrage desdits signaux, par exemple un filtre analogique ; de préférence, les premiers moyens comprennent des moyens d'échantillonnage pour obtenir un certain nombre de valeurs discrètes, par exemple à fréquence 500 Hz ou 600 Hz.

Le dispositif selon l'invention comprend des deuxièmes moyens de traitement des signaux représentatifs obtenus associés à des moyens d'activation desdits moyens de traitement, les moyens d'activation étant déclenchés par la détection de l'occurrence d'un défaut. De préférence, la détection de l'occurrence d'un défaut actionnant les moyens d'activation est réalisée par le dispositif selon l'invention qui comprend des moyens adaptés, notamment des moyens pour comparer les signaux représentatifs des courants de phase de la ligne à une ou des valeurs de référence.

Les deuxièmes moyens de traitement des signaux du dispositif selon l'invention comprennent des moyens pour déterminer le courant pseudo-homopolaire issu des premiers paramètres, et pour en faire une analyse fréquentielle, en particulier en comparant les composantes d'harmonique deux et un avec la composante continue. Avantageusement, les deuxièmes moyens du dispositif selon l'invention comprennent en outre des moyens pour calculer la moyenne arithmétique des signaux représentatifs des normes de chacune des phases. De préférence, les moyens de calcul sont associés à des moyens de temporisation permettant l'acquisition des signaux pendant une durée correspondant à un nombre entier de demi-périodes du réseau. Des moyens peuvent être prévus pour comparer les signaux représentatifs des normes de chacune des phases avec leur valeur avant défaut.

Les moyens de traitement des signaux sont couplés en sortie à des moyens d'interprétation qui permettent d'identifier la nature du défaut et d'en déterminer la position relative par rapport au point d'obtention desdits signaux. Les moyens d'interprétation comprennent des comparateurs entre les harmoniques déterminées, entre la moyenne calculée et chacun des signaux ayant servi à calculer ladite moyenne.

Notamment, le dispositif d'identification d'un défaut dans un réseau triphasé selon l'invention comporte : des premiers moyens pour fournir des paramètres représentatifs des courants de chacune des phases comprenant des moyens de réception de signaux représentatifs des courants de chacune des phases, des moyens de redressement mono-alternance desdits signaux fournissant des premiers paramètres ; des deuxièmes moyens de traitement des paramètres représentatifs comprenant des moyens de calcul du courant résultant de la somme des premiers paramètres et des moyens d'analyse fréquentielle dudit résultat comprenant une comparaison de ses composantes d'harmonique zéro et d'harmonique deux par rapport à la fréquence propre du réseau ; des moyens d'activation desdits deuxièmes moyens de traitement en fonction d'un signal de détection de l'occurrence d'un défaut dans le réseau ; des moyens d'interprétation des résultats du traitement par les deuxièmes moyens des premiers paramètres pour déterminer si le défaut est biphasé. Les moyens d'analyse fréquentielle des deuxièmes moyens peuvent comprendre en outre une comparaison des composantes d'harmonique zéro et d'harmonique un du résultat issu de la somme des premiers paramètres et les moyens d'interprétation des résultats du traitement des premiers paramètres peuvent alors être aptes à déterminer si le défaut est monophasé.

Le dispositif précédent peut être adapté pour la détection directionnelle du défaut avec les premiers moyens comprenant en outre des moyens de calcul d'une norme des signaux représentatifs des courants de chaque phase fournissant des deuxièmes paramètres, et les deuxièmes moyens comprenant en outre des moyens de calcul de la moyenne des normes sur une durée prédéterminée et des moyens de comparaison de chacune des normes avec ladite moyenne calculée, les moyens d'interprétation étant alors adaptés pour traiter le résultat du traitement par les deuxièmes moyens des deuxièmes paramètres pour déterminer si le défaut est en amont ou en aval du dispositif. Lorsque les moyens d'analyse fréquentielle des deuxièmes moyens comprennent en outre une comparaison de l'harmonique zéro du résultat issu de la somme des premiers paramètres à un seuil, les moyens d'interprétation des résultats du traitement par les deuxièmes moyens des premiers paramètres peuvent être aptes à identifier un défaut triphasé et à le localiser en amont ou en aval du dispositif.

Le dispositif d'identification peut en outre comprendre des moyens de détection de l'occurrence d'un défaut de type court-circuit dans le réseau reliés aux moyens d'activation des moyens de traitement des signaux. En particulier, ses deuxièmes moyens peuvent comprendre des moyens de stockage d'une valeur des deuxièmes paramètres et lesdits moyens de détection comprendre des moyens pour comparer chacun des deuxièmes paramètres à la valeur stockée.

Ainsi, le procédé d'identification d'un défaut biphasé selon l'invention comprend les étapes successives de : déclenchement suite à l'obtention d'un signal indicateur de la présence dudit défaut ; obtention de signaux représentatifs de chacun des courants de phase sur une durée d'au moins une demi-période du réseau ; redressement mono-alternance des signaux représentatifs des courants de phase ; sommation vectorielle des signaux redressés ; analyse fréquentielle de la sommation vectorielle des signaux redressés ; comparaison du signal d'harmonique 2 au signal d'harmonique 0 de l'analyse fréquentielle. Une comparaison du signal d'harmonique 1 au signal d'harmonique de l'analyse fréquentielle peut être prévue. Pour être adapté à la localisation relative du défaut, le procédé comprend en outre la détermination d'une norme représentative du courant de chaque phase ; le calcul de la moyenne arithmétique des normes de chacun des courants de phase sur une durée prédéterminée ; l'interprétation des résultats du traitement des signaux, pour indiquer si le défaut détecté se situe en aval ou en amont de l'endroit où les signaux représentatifs des normes des courants de phase ont été obtenus, par une comparaison entre ladite moyenne et lesdits signaux représentatifs de la norme de chacun des courants de phase.

### BREVE DESCRIPTION DES FIGURES

D'autres avantages et caractéristiques ressortiront plus clairement de la description qui suit de modes particuliers de réalisation de l'invention, donnés à titre illustratif et nullement limitatifs, représentés dans les figures annexées.
La figure 1, déjà décrite, représente un réseau électrique muni de dispositifs de détection de défaut de type court-circuit.
La figure 2 montre les différents signaux utilisés dans un procédé de détection selon l'invention, pour un défaut biphasé isolé en aval d'un dispositif de détection.
La figure 3 montre de façon schématique et filtrée des signaux représentatifs des courants de phase et du courant pseudo-homopolaire lors de l'apparition d'un défaut biphasé à la terre, respectivement à l'aval et à l'amont du dispositif de détection.
Les figures 4A et 4B illustrent le procédé de détection de l'invention et un de ses modes de réalisation préférés.
La figure 5 représente un schéma bloc d'un dispositif de détection directionnelle de défaut selon un mode de réalisation préféré de l'invention.

### DESCRIPTION DETAILLEE D'UN MODE DE REALISATION PREFERE

Le dispositif 15 de détection directionnelle de défaut 10 selon l'invention peut être utilisé dans tout réseau triphasé 1, tel que celui décrit en figure 1, en lieu et place des dispositifs 6 existants ; en particulier, bien que la description concerne un réseau 1 de fréquence propre F = 50 Hz, le dispositif et le procédé selon l'invention s'adaptent de façon immédiate aux autres fréquences. La description sera faite ci-après pour un réseau 1 équilibré, c'est-à-dire qu'en l'absence de défaut, le courant homopolaire I₀ (ou « *zero sequence current* » selon la terminologie anglo-saxonne) est nul, mais ceci n'est pas limitatif.

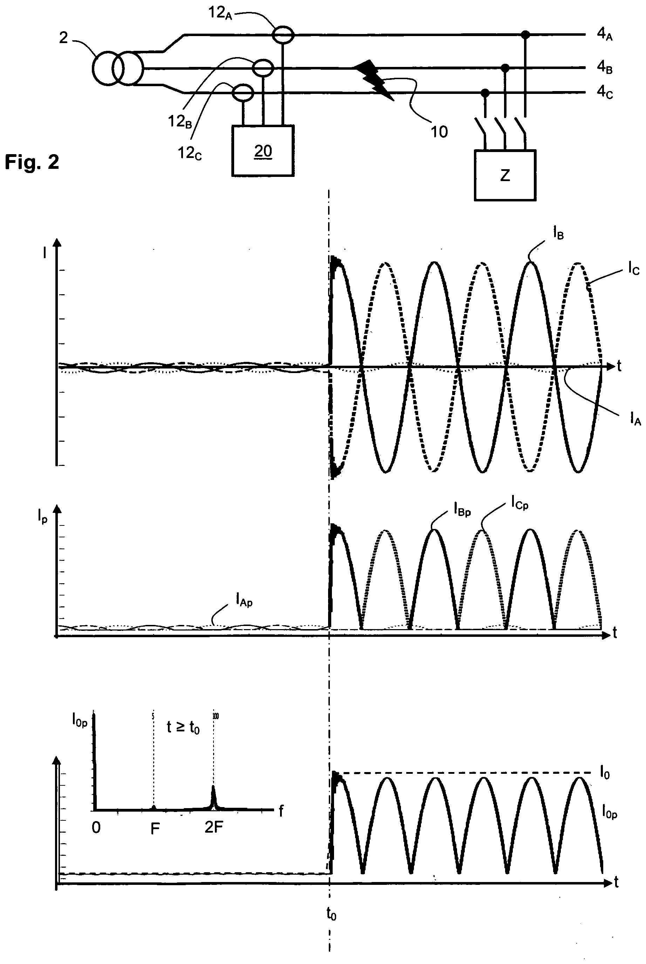

Tel qu'illustré en figure 2, des moyens 20 fournissent un ou des signaux représentatifs du courant circulant dans chacun des trois conducteurs de phase 4_{A}, 4_{B}, 4_{C} de la ligne 4 ; avantageusement, les moyens de mesure du courant 20 font partie du dispositif 15 selon l'invention mis en place sur ladite ligne 4, et ils sont couplés à des dispositifs de mesure directement localisés sur la ligne 4, notamment des tores de détection 12_{A}, 12_{B}, 12_{C}. Lors de l'apparition d'un défaut 10 sur le réseau triphasé 1, le courant d'au moins une phase est altéré, notamment en amont du défaut 10, tout comme le courant homopolaire I₀. En outre, tel que schématisé, le courant I₀ₚ résultant de la somme des alternances de même polarité de chaque phase I_{Ap}, I_{Bp}, I_{Cp} est également modifié ; ce courant, appelé par la suite *« courant pseudo-homopolaire* » présente des caractéristiques additionnelles générées par une absence de lissage des composantes haute fréquence. Ainsi, dans le cas d'un défaut biphasé isolé 10 localisé en aval d'un dispositif 12 de détection des courants de phase I_{X}, on constate l'altération du courant des deux phases B et C en défaut, alors que le courant de la troisième phase I_{A} reste sensiblement constant. Si le courant homopolaire résultant I₀ présente une discontinuité, le courant pseudo-homopolaire I₀ₚ montre en outre des composantes fréquentielles distinctes, notamment à une fréquence f double de la fréquence propre F du réseau 1.

Que le défaut biphasé soit isolé ou à la terre, localisé en amont ou en aval d'un détecteur de courant 12, la composante I_{0p 100} à 100 Hz du courant pseudo-homopolaire I₀ₚ après défaut est supérieure à 20 % de la composante continue I_{0p DC}, ce qui n'est pas le cas lors d'un défaut monophasé. Selon l'invention, ce signal I₀ₚ représentatif du courant circulant dans la ligne 4 est donc utilisé pour identifier la nature N d'un défaut 10.

Comme une variation de charge Z produit également une composante à 100 Hz qui peut dépasser 50 % de la composante continue, pour éliminer définitivement un simple enclenchement/déclenchement de charge Z, il est préférable de vérifier en outre la composante d'harmonique un de la ligne 4 après défaut : de fait, aucune composante à la fréquence propre F du réseau 1 n'est générée pour une variation de charge Z, alors qu'un défaut mono- ou biphasé l'altère également, avec cette composante I_{0p 50} dépassant notamment 5 % de la composante continue I_{0p DC}. Une autre option serait de vérifier que les trois courants de phase I_{A}, I_{B}, I_{C} varient dans le même sens, signe qu'une variation de charge Z cause la discontinuité, alors que si deux des courants varient dans un sens et le troisième dans l'autre, un défaut biphasé 10 est survenu.

Ainsi, selon l'invention, une fois qu'un défaut 10 est détecté D sur le réseau 1, pour identifier la nature N biphasée du défaut 10, le courant I_{X} de chaque phase est mesuré, redressé en mono-alternance I_{Xp}, puis sommé I₀ₚ; le spectre harmonique de ladite somme I₀ₚ après défaut est analysé, et la composante I_{0p 2F} à 100 Hz est considérée. Si cette composante est supérieure à 20 % de la composante continue I_{0p DC}, et si une composante I_{0p F} à 50 Hz existe, alors il y a un défaut biphasé. La détection initiale D d'un défaut peut être réalisée par tout moyen existant, par exemple tel que décrit en relation avec le document FR 2 936 319.

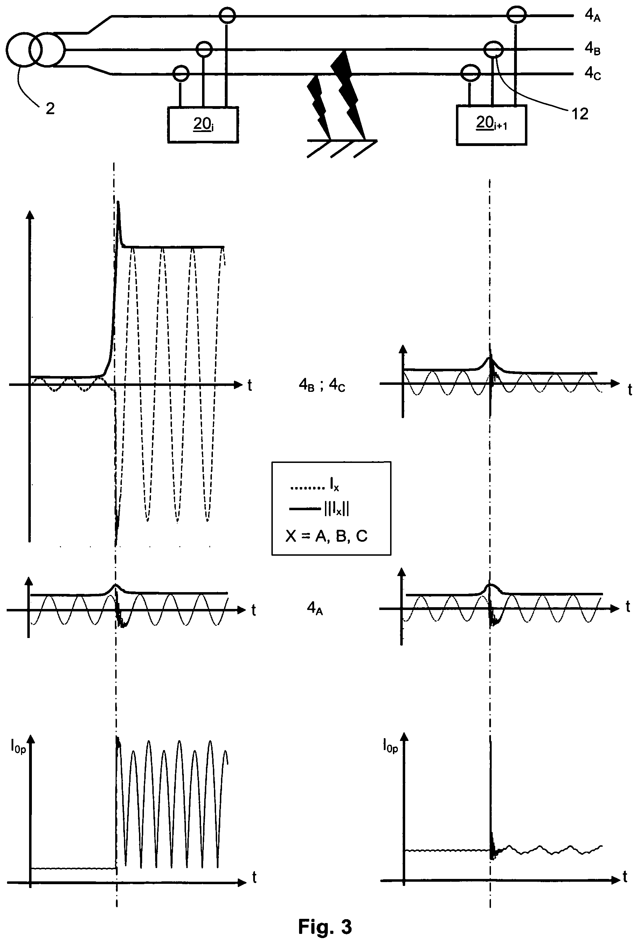

En outre, en se penchant sur les signaux représentatifs des courants de phase I_{X} eux-mêmes, il est possible de distinguer si ledit défaut biphasé 10 est localisé en aval ou en amont du détecteur 20ᵢ, 20ᵢ₊₁. De fait, tout comme pour le défaut à la terre monophasé (voir FR 2 936 378), suivant sa localisation relative, la variation différentielle de l'amplitude du courant ∥I_{X}∥ ne suit pas le même profil. En particulier, lorsque le défaut 10 est en aval du détecteur 20ᵢ, il apparaît que les courants des deux phases I_{B}, I_{C} en défaut sont fortement augmentés, de façon analogue l'un et l'autre, alors que le courant de la troisième phase ∥I_{A}∥ est peu altéré ; au contraire, pour le même défaut, les moyens de détection aval 20ᵢ₊₁ donnent un courant de la phase non altérée A qui varie légèrement et une amplitude qui reste sensiblement constante (légèrement diminuée) pour les deux phases B, C en défaut : voir figure 3 pour un défaut 10 biphasé à la terre. Une comparaison de l'amplitude ∥Ix∥ du courant de chaque phase avec la moyenne µ de l'amplitude des trois courants de phase I_{X} permet ainsi de distinguer un défaut biphasé amont d'un défaut biphasé aval.

Selon l'invention, la moyenne µ des signaux représentatifs des amplitudes des courants de chaque phase ∥I_{X}∥ est donc calculée puis sa position par rapport à ses différents composants est déterminée pour localiser le défaut 10 par rapport aux capteurs 12 et aux moyens 20 fournissant des signaux représentatifs des courants I_{X} de la ligne 4, de préférence filtrés. Avantageusement, les signaux sont analysés sur une durée suffisante T_{acq}, avec notamment une acquisition des signaux supérieure à une demi-période du réseau 1, par exemple une période 1/F ou tout nombre entier de demi-périodes. La localisation en tant que telle dépend du nombre de fois où la moyenne µ est supérieure aux éléments utilisés pour la calculer : si la moyenne des amplitudes est une seule fois supérieure aux amplitudes, le défaut biphasé est en aval.

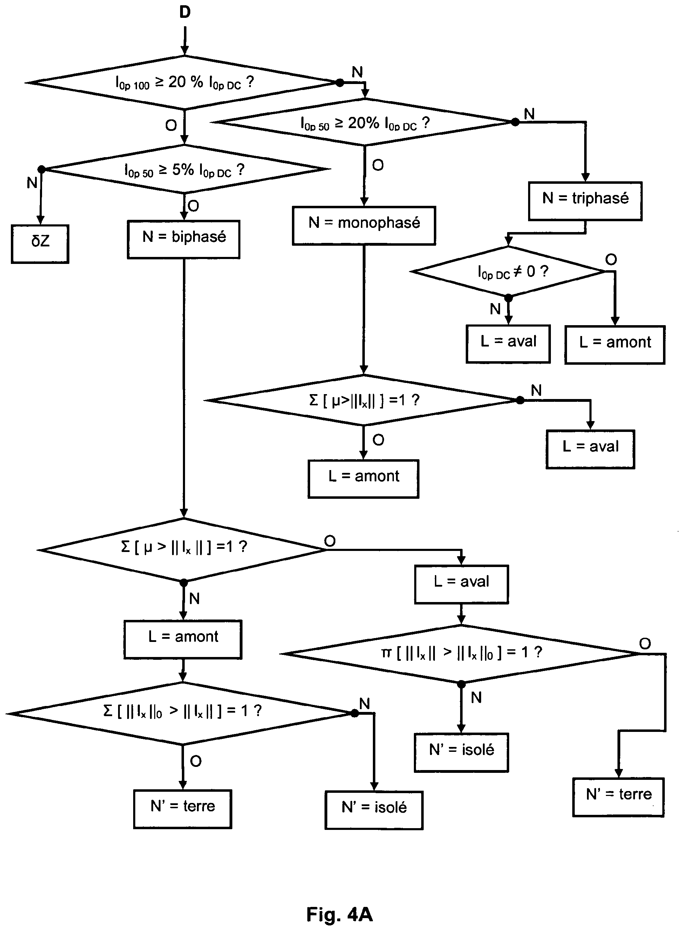

Tel qu'illustré également en figure 4A, en étudiant la variation globale des amplitudes avant et après survenue du défaut 10, une distinction entre un défaut biphasé à la terre ou un défaut biphasé isolé est également possible : en amont d'un défaut biphasé à la terre, les courants I_{X} des trois phases augmentent en amplitude, alors que seules deux sont affectées pour un défaut isolé ; en aval d'un défaut biphasé à la terre, un courant augmente en amplitude, alors que pour un défaut biphasé isolé, il n'y a pas d'augmentation d'amplitude. Il est possible par ailleurs de combiner ce procédé d'identification et de localisation relative des défauts biphasés avec l'identification et/ou la localisation d'un défaut monophasé : lorsque la composante 100 Hz est absente, si une composante à 50 Hz est présente, alors un défaut monophasé est identifié. En utilisant la méthode précédente de comparaison des amplitudes ∥I_{X}∥ de courant, tel qu'également décrit dans le document FR 2 936 378, il est possible de distinguer si le défaut 10 est en amont ou en aval du dispositif de mesure du courant 12, 20 : la moyenne µ des signaux représentatifs des amplitudes des courants de chaque phase ∥I_{X}∥ est calculée puis sa position par rapport à ses différents composantes est déterminée; la localisation L dépend du nombre de fois où la moyenne µ est supérieure aux éléments utilisés pour la calculer (si la moyenne des amplitudes est une seule fois supérieure aux amplitudes, le défaut est en amont).

En l'absence de composante à 100 Hz et à 50 Hz, si un défaut 10 a été détecté préalablement D, le défaut est triphasé, et il est possible de le localiser : lorsqu'aucune composante continue I_{0p DC} n'est présente dans les courants détectés I_{X}, soit la ligne 1 n'est pas alimentée, soit un défaut triphasé est survenu en amont ; lorsqu'il n'existe qu'une composante continue (à l'exception d'une composante à 100 Hz et d'une composante à 50 Hz) alors un défaut triphasé est survenu en aval des moyens de détection du courant 20.

Une analyse des courants de phase I_{X} après défaut 10, de leur amplitude ∥I_{X}∥ et de la sommation vectorielle de leur alternance de même polarité I₀ₚ permet ainsi d'identifier N et de localiser L un défaut 10. Par ailleurs, si des moyens de stockage des valeurs représentatives de l'amplitude des courants de phase I_{X} sont prévus et qu'il est possible de comparer les valeurs avant et après défaut, la nature N' d'un défaut biphasé peut être identifiée. Il peut dans ce cas être souhaitable d'utiliser les moyens de stockage pour procéder à la détection initiale de la présence D d'un défaut 10 à la place de la comparaison du courant homopolaire I₀ à un seuil, dont la valeur peut dépendre non seulement du réseau, mais aussi de son état de charge ou de la nature résistive dudit défaut : à chaque échantillonnage des signaux représentatifs I_{X}, par exemple à la fréquence propre F du réseau 1, une comparaison des amplitudes ∥I_{X}∥ₜ des courants de phase à une référence ∥I_{X}∥_{ref} peut de la même façon mener au déclenchement du processus d'identification et de localisation ; la valeur de référence ∥I_{X}∥_{ref} peut être fixée ou être mise à jour à chaque calcul de la norme, pour une comparaison entre le signal à un instant t et à un instant t + 1.

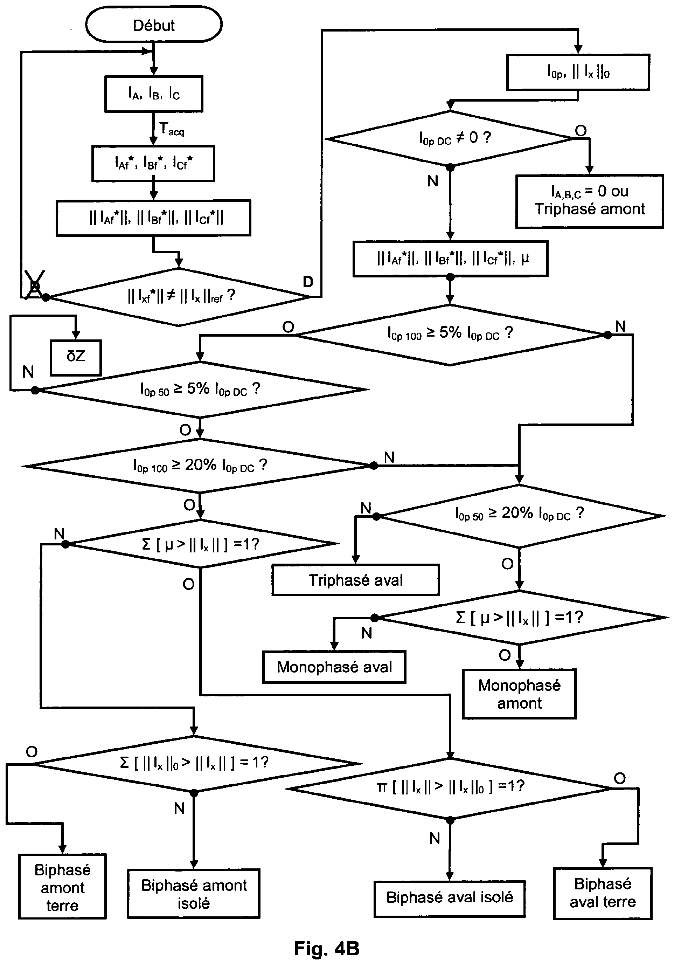

Afin de limiter les calculs et optimiser les temps de traitement des données, des étapes intermédiaires peuvent être effectuées et/ou les étapes précédentes peuvent être réalisées dans un ordre différent. Un mode préféré de réalisation du procédé selon l'invention est schématisé en figure 4B, dans lequel les courants I_{X} de chaque phase sont mesurés à intervalles réguliers, par exemple toutes les 1,5 ms ; de préférence, les signaux représentatifs des courants de phase sont filtrés I_{Af}, I_{Bf}, I_{Cf}, acquis sur une durée d'acquisition T_{acq} et échantillonnés ; selon l'invention, de cinq à dix valeurs d'amplitudes sur une durée de l'ordre d'une demi-période ou d'une période de réseau 1 est suffisante - une fréquence d'échantillonnage de l'ordre de 500 à 1000 Hz pour un courant triphasé à 50 Hz est par exemple adaptée au procédé selon l'invention. La norme desdits signaux échantillonnés filtrés ∥I_{Af}*∥, ∥I_{Bf}*∥, ∥I_{Cf}*∥ est ensuite déterminée par les formules appropriées à la norme choisie.

Les valeurs ∥I_{Xf}*∥ ainsi obtenues comparées à une norme de référence ∥I_{X}∥_{ref} qui peut être fixe, ou caractéristique d'une période précédente d'acquisition dans un réseau sans défaut : si une différence significative pour l'une des phases X est détectée, par exemple une différence supérieure à 5 ou 6 %, un défaut 10 est considéré comme détecté D, et le procédé d'identification et de localisation en tant que tel est déclenché. La dernière valeur ∥I_{A}∥₀, ∥I_{B}∥₀, ∥I_{C}∥₀ des normes avant défaut (t < t₀) est mise en mémoire.

Après identification du défaut, les signaux représentatifs de courants de phase I_{X} sont acquis sur une durée d'acquisition T_{acq} et le courant pseudo-homopolaire I₀ₚ calculé. La composante continue du courant I_{0p DC} est comparée à un seuil : en son absence, le défaut concerne un défaut triphasé amont ou une ligne non alimentée. Les composantes I_{0p 50} et I_{0p 100} à 50 Hz et 100 Hz du courant pseudo-homopolaire I₀ₚ sont également comparées à un seuil bas, par exemple 5 % de la composante continue I_{0p DC}, afin d'identifier une variation de charge Z.

Dans les autres cas, une détermination des amplitudes de courants de phase ∥I_{Af}*∥, ∥I_{Bf}*∥, ∥I_{Cf}*∥ filtrés échantillonnés après défaut sur la durée d'acquisition est effectuée, leur moyenne arithmétique µ est calculée. De plus, les composantes à 50 Hz et à 100 Hz du pseudo-homopolaire I_{0p 50}, I_{0p 100} sont comparées à des seuils plus élevés, notamment à 20 % de la composante continue I_{0p DC}, afin d'identifier la nature monophasée ou biphasée du défaut détecté 10 ; la comparaison peut être simultanée ou successive, en commençant alors par la composante à 100 Hz. La moyenne arithmétique µ est comparée ensuite à chacune des normes ∥I_{Af}*∥, ∥I_{Bf}*∥, ∥I_{Cf}*∥ prises individuellement, de façon à localiser relativement le défaut en amont ou en aval du point d'obtention du signal représentatif des courants de phase I_{A}, I_{B}, I_{C}. Une étape supplémentaire de comparaison des normes après défaut ∥I_{Af}*∥, ∥I_{Bf}*∥, ∥I_{Cf}*∥ par rapport aux normes avant défaut ∥I_{A}∥₀, ∥I_{B}∥₀, ∥I_{C}∥₀ peut être réalisée pour les défauts biphasés amont, afin de préciser la nature N' dudit défaut biphasé 10.

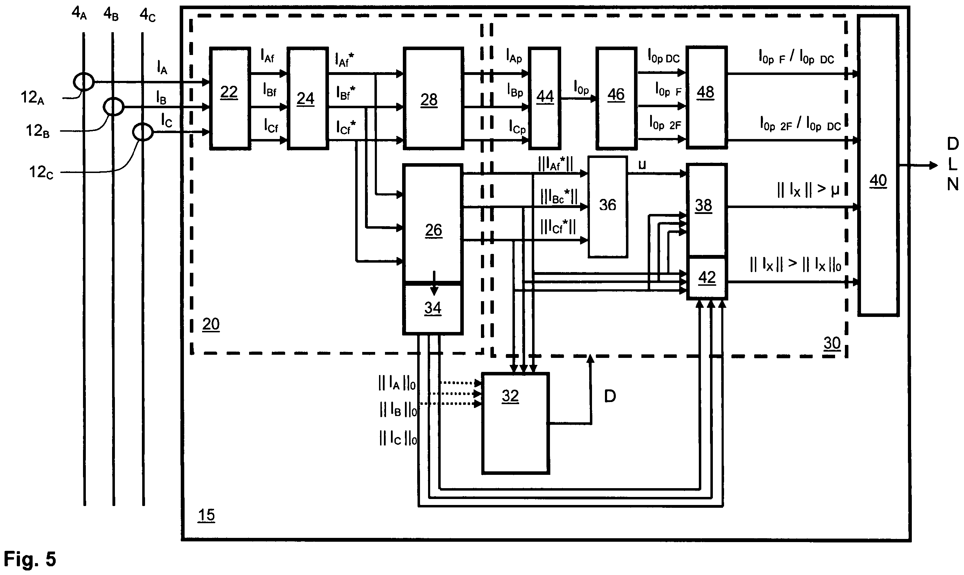

Le procédé selon l'invention peut être mis en place dans un relai de protection 8, dans un indicateur de défaut avec système d'alerte 7, par implémentation dans un dispositif de détection directionnelle de défaut 15 adapté. Un dispositif 15 selon un mode de réalisation préféré de l'invention est schématisé en figure 5, ledit dispositif étant associé à des capteurs 12, par exemple des tores de détection, et comprenant de préférence les moyens 20 d'obtention des signaux représentatifs de courant de phase I_{X} fournis par les capteurs 12.

Les moyens d'obtention 20 comprennent avantageusement des moyens de filtrage 22 comme un filtre analogique. Dans le mode de réalisation préféré, les signaux filtrés I_{Af}, I_{Bf}, I_{Cf} sont en outre conditionnés dans un module d'échantillonnage 24, fonctionnant notamment à moins de 1 kHz, fournissant ainsi des signaux échantillonnés filtrés I_{Af}*, I_{Bf}*, I_{Cf}* à des moyens de calcul 26 de leur norme, amplitude, valeur efficace ou autre ∥I_{Af}*∥, ∥I_{Bf}*∥, ∥I_{Cf}*∥; de plus, les moyens d'obtention comprennent des moyens de redressement mono-alternance 28 permettant de fournir un signal de phase I_{Xp} pour le calcul du courant pseudo-homopolaire I₀ₚ. Les paramètres I_{Xp} et ∥I_{Xf}*∥ sont ensuite traités au sein d'un module de traitement 30.

Le module de traitement 30 est activé en fonction de la détection d'un défaut 10. A cette fin, le module de traitement 30 est connecté à un dispositif de détection de défaut 32 quelconque ; en particulier, le dispositif de détection de défaut 32 comprend des moyens pour comparer la norme ∥I_{Xf}*∥ calculée par le module adapté 26 du module de détection 20 avec une référence ∥I_{X}∥_{ref}: si une différence sur l'une des phases dépasse un seuil, alors un défaut D est détecté et le module de traitement 30 est activé.

Avantageusement, une valeur des normes des courants de phase est stockée dans une mémoire 34 tant que l'activation D n'a pas lieu ; cette valeur mise en mémoire peut alors être utilisée comme valeur de référence dans les moyens d'activation 32. Par exemple, à chaque échantillonnage, le résultat ∥I_{Af}*∥, ∥I_{Bf}*∥, ∥I_{Cf}*∥ est mis en mémoire, l'activation du module de traitement 30 entraînant parallèlement la désactivation de la mémoire 34, de sorte que la dernière valeur des normes ∥I_{A}∥₀, ∥I_{B}∥₀, ∥I_{C}∥₀ représentative du courant juste avant défaut 10 est conservée.

Le module de traitement 30 comprend ainsi une entrée relative au signal D issu du dispositif de détection de défaut 32 ; de plus, trois entrées relatives aux moyens de calcul de la norme du courant 26 sont reliées à un dispositif de calcul 36 de moyenne arithmétique µ des trois données entrées ∥I_{Af}*∥, ∥I_{Bf}*∥, ∥I_{Cf}*∥; un dispositif de comparaison 38 avec quatre entrées, ces trois valeurs et la moyenne calculée, est ensuite relié à des moyens d'interprétation 40. Les moyens de comparaison 38 comparent chacune des valeurs de norme ∥I_{Xf}*∥ avec leur moyenne µ et donnent avantageusement un signal binaire selon le sens de la comparaison aux moyens d'interprétation 40.

Ces trois entrées, associées aux valeurs ∥I_{X}∥₀ stockées en mémoire 34, sont également reliées à un module 42 de comparaison relative des amplitudes qui est relié aux mêmes moyens d'interprétation 40 ; les moyens de comparaison 42 comparent chacune des valeurs de norme ∥I_{Xf}*∥ avec leur valeur stockée ∥I_{X}∥₀ et donnent un signal en fonction du nombre d'augmentations relatives aux moyens d'interprétation 40. Alternativement, quatre signaux binaires peuvent être fournis en fonction de la comparaison du nombre d'augmentations à un et trois.

Par ailleurs, le module de traitement 30 comprend trois entrées pour les données issues du module 28 de redressement mono-alternance reliées à un dispositif 44 de calcul du courant pseudo-homopolaire, dont la sortie est reliée à des moyens de détermination 46 des coefficients de Fourier de rang 0, 1 et 2 ; les coefficients sont entrés dans des moyens de comparaison 48 qui fournissent deux sorties relatives à la valeur des rapports des coefficient de Fourier des niveau 2 et 1 avec le coefficient de Fourier de niveau 0, ou quatre sorties binaires fonction de la comparaison de ces rapports à deux seuils, par exemple 5 % et 20 %. Les résultats sont eux aussi transmis au module d'interprétation 40.

Le module d'interprétation 40 donne alors un résultat précisant la réalité D du défaut, sa nature N (voire N') et sa localisation relative L par rapport aux capteurs 12. Les moyens 36 de calcul de la moyenne µ, tout comme les moyens de détermination des normes 26, sont associés à des moyens de temporisation afin de s'assurer que les signaux représentatifs des normes des courants de phase ∥I_{Af}*∥, ∥I_{Bf}*∥, ∥I_{Cf}*∥ ont été acquis sur une durée suffisante T_{acq}, par exemple une demi-période ou une période du réseau 1, voire plus.

Le dispositif de la figure 5 peut être avantageusement associé à un relai de protection 8 pour des réseaux électriques, ou à un indicateur de passage de défaut pour des lignes 4 moyenne tension souterraines connectées en réseau 1, la sortie du module d'interprétation 40 déclenchant la coupure d'un disjoncteur 5, l'allumage d'un voyant 7 ou tout autre moyen de sécurité et/ou d'alerte.

Ainsi, selon l'invention, un procédé et un dispositif 15 d'identification et de détection directionnelle d'un défaut 10 d'une ligne d'un réseau triphasé 1 ont été réalisés sans mesure de tension, ce qui allège autant les dispositifs que leur mise en oeuvre : par analyse simultanée des amplitudes des courants de phase immédiatement après le défaut, des variations phase à phase des amplitudes de courant, et des composantes harmoniques du courant pseudo-homopolaire, il est possible d'assurer la détection, la discrimination et l'orientation du défaut.

Bien que l'invention ait été décrite en référence à un réseau 1 de distribution triphasé 50 Hz dans lequel le neutre est mis à la terre par impédance compensée, elle ne s'y limite pas.

D'autres régimes de neutre peuvent être concernés par l'invention, et d'autres fréquences propres F ; par ailleurs, bien que présenté avec l'amplitude du courant, le procédé selon l'invention peut également être appliqué avec toute norme représentative de la variation du signal représentatif du courant de phase. Notamment, l'amplitude peut être remplacée par la valeur efficace (« *Root Mean Square Value* » selon la terminologie anglo-saxonne), ou par la norme euclidienne (c'est-à-dire la norme 2), ou encore par la norme 1 (également connue sous le nom de « *Taxicab norm* » ou *« Manhattan norm* »), voire la norme infinie (ou norme sup).

Les différents circuits, modules et fonctions présentés dans le cadre du mode de réalisation préféré de l'invention peuvent être réalisés en composants analogiques, numériques ou sous une forme programmable opérant avec des microcontrôleurs ou des microprocesseurs, et les signaux représentatifs décrits peuvent avoir des formes de signaux électriques ou électroniques, de valeurs de données ou d'information dans des mémoires ou des registres, de signaux optiques visualisables notamment sur des voyants ou des écrans, ou de signaux mécaniques agissant avec des actionneurs. De même, les capteurs de courant peuvent être différents des transformateurs décrits, comme des capteurs à effet Hall ou des magnétorésistances. En outre, les différents modules présentés peuvent être organisés de façon différente : les moyens de calcul de la norme 26 peuvent par exemple être extérieurs au module 20 d'obtention de signaux représentatifs du courant, tout comme le module de détermination 28 des courants de phase redressés mono-alternance I_{Xp}.

## Revendications

1. Dispositif (15) d'analyse utilisé dans un réseau triphasé (1) ayant une fréquence propre (F) comportant :
- des premiers moyens (20) pour fournir des paramètres représentatifs des courants (I_{X}) de chacune des phases comprenant des moyens de, réception (22) de signaux représentatifs des courants de chacune des phases, des moyens de redressement mono-alternance (28) desdits signaux fournissant des premiers paramètres (I_{Xp});
- des deuxièmes moyens de traitement (30) des paramètres représentatifs comprenant des moyens de calcul (44) du courant résultant de la somme (I₀ₚ) des premiers paramètres (I_{Xp}) et des moyens d'analyse fréquentielle (46, 48) dudit résultat (I₀ₚ);
**caractérisé en ce que** :
- les moyens d'analyse fréquentielle (46, 48) des deuxièmes moyens de traitement (30) comprennent une comparaison des composantes d'harmonique zéro (I_{0p DC}) et d'harmonique deux (I_{0p 2F}) du résultat (I₀ₚ) des moyens de calcul (44) par rapport à la fréquence propre (F) du réseau (1) ; et
- ledit dispositif d'analyse (15) est adapté pour l'identification d'un défaut (10) dans un réseau triphasé (1), et comprend en outre :
- des moyens d'activation (32) desdits deuxièmes moyens de traitement (30) en fonction d'un signal (D) de détection de l'occurrence d'un défaut (10) dans le réseau (1) ;
- des moyens (40) d'interprétation des résultats du traitement par les deuxièmes moyens (30) des premiers paramètres (I_{Xp}) pour déterminer si le défaut (10) est biphasé.

2. Dispositif (15) d'identification selon la revendication 1 dans lequel les moyens d'analyse fréquentielle (46, 48) des deuxièmes moyens (30) comprennent en outre une comparaison des composantes d'harmonique zéro (I_{0p DC}) et d'harmonique un (I_{0p F}) par rapport à la fréquence propre (F) du réseau (1) du résultat (I₀ₚ) issu de la somme des premiers paramètres (I_{Xp}), et dans lequel les moyens d'interprétation (40) des résultats du traitement des premiers paramètres (I_{Xp}) sont aptes à déterminer si le défaut (10) est monophasé.

3. Dispositif (15) d'identification et de détection directionnelle d'un défaut (10) dans un réseau triphasé (1) ayant une fréquence propre (F) comprenant un dispositif d'identification selon l'une des revendications 1 ou 2 dans lequel :
- les premiers moyens (20) comprennent en outre des moyens de calcul (26) d'une norme des signaux représentatifs des courants de chaque phase (I_{X}) fournissant des deuxièmes paramètres (∥I_{X}∥);
- les deuxièmes moyens (30) comprennent en outre des moyens de calcul (36) de la moyenne (µ) des deuxièmes paramètres (∥I_{X}∥) sur une durée prédéterminée (T_{acq}) et des moyens de comparaison (38) de chacune des normes (∥I_{X}∥) avec ladite moyenne calculée (µ) ;
- les moyens (40) d'interprétation sont adaptés pour traiter le résultat du traitement par les deuxièmes moyens (30) des deuxièmes paramètres (∥I_{X}∥) pour déterminer si le défaut est en amont ou en aval du dispositif (15).

4. Dispositif d'identification et de détection directionnelle (15) selon la revendication 3 dans lequel les moyens d'analyse fréquentielle (46, 48) des deuxièmes moyens (30) comprennent en outre une comparaison de l'harmonique zéro (I_{0p DC}) du résultat (I₀ₚ) issu de la somme des premiers paramètres (I_{Xp}) à un seuil et dans lequel les moyens d'interprétation (40) des résultats du traitement par les deuxièmes moyens (30) des premiers paramètres (I_{Xp}) sont aptes à identifier un défaut triphasé et à le localiser en amont ou en aval du dispositif (15).

5. Dispositif d'identification et de détection directionnelle (15) selon l'une des revendications 3 ou 4 dans lequel les premiers moyens (20) comprennent des moyens d'échantillonnage (24) et des moyens de stockage (34) d'une valeur de référence (∥I_{X}∥₀) issue des moyens de calcul de la norme (26) avant défaut.

6. Dispositif d'identification et de détection directionnelle (15) selon la revendication 5 dans lequel les deuxièmes moyens (30) comprennent des moyens (42) pour comparer les deuxièmes paramètres (∥I_{X}∥) à la norme de référence (∥I_{X}∥₀) des moyens de stockage (34), et les moyens d'interprétation (40) des résultats du traitement des deuxièmes paramètres (∥I_{X}∥) sont aptes à identifier la nature du défaut biphasé (10).

7. Dispositif d'identification (15) selon l'une des revendications 1 à 6 comprenant en outre des moyens (32) de détection de l'occurrence d'un défaut de type court-circuit (10) dans le réseau (1) reliés aux moyens d'activation des moyens de traitement des signaux (30).

8. Dispositif d'identification et de détection directionnelle (15) selon la revendication 6 dans lequel les deuxièmes moyens (30) comprennent des moyens de stockage (34) d'une valeur des deuxièmes paramètres (∥I_{X}∥_{ref}) et comprenant en outre des moyens (32) de détection de l'occurrence d'un défaut de type court-circuit (10) dans le réseau (1) reliés aux moyens d'activation des moyens de traitement des signaux (30) et aux moyens de stockage (34), lesdits moyens de détection (32) comprenant des moyens pour comparer chacun des deuxièmes paramètres (∥I_{X}∥) à la valeur stockée (∥I_{X}∥_{ref}).

9. Indicateur de passage de défaut de type court-circuit comprenant des capteurs de courant (12_{A}, 12_{B}, 12_{C}) disposés sur chaque conducteur de phase (4_{A}, 4_{B}, 4_{C}) d'un réseau électrique (1) à surveiller et comprenant un dispositif d'identification de défaut (15) selon l'une des revendications 1 à 8 connecté auxdits capteurs de courant (12_{A}, 12_{B}, 12_{C}) pour recevoir les signaux représentatifs des normes des courants de phase (∥I_{X}∥).

10. Relai (8) de protection à la terre comprenant au moins un indicateur de défaut selon la revendication 9 et des moyens d'actionnement d'un dispositif de coupure (5) en fonction des résultats des moyens d'interprétation (40) du dispositif d'identification (15) de l'indicateur.

11. Procédé d'identification (N) d'un défaut (10) dans un réseau triphasé (1) comprenant les étapes successives de :
- déclenchement suite à l'obtention d'un signal (D) indicateur de la présence dudit défaut (10);
- obtention de signaux représentatifs de chacun des courants de phase sur une durée (T_{acq}) d'au moins une demi-période du réseau ;
- redressement mono-alternance des signaux représentatifs des courants de phase (I_{A}, I_{B}, I_{C});
- sommation vectorielle (I₀ₚ) des signaux redressés (I_{Ap}, I_{Bp}, I_{Cp});
- analyse fréquentielle de la sommation vectorielle des signaux redressés (I₀ₚ);
- comparaison du signal d'harmonique 2 (I_{0p 2F}) au signal d'harmonique 0 (I_{0p DC}) de l'analyse fréquentielle.

12. Procédé selon la revendication 11 comprenant en outre une comparaison du signal d'harmonique 1 (I_{0p F}) au signal d'harmonique 0 (I_{0p DC}) de l'analyse fréquentielle.

13. Procédé d'identification (N) et de localisation relative (L) d'un défaut (10) dans un réseau triphasé (1) comprenant un procédé d'identification selon l'une des revendications 11 ou 12 et comprenant en outre :
- la détermination d'une norme (∥I_{A}∥, ∥I_{B}∥, ∥I_{C}∥) représentative du courant de chaque phase ;
- le calcul de la moyenne arithmétique (µ) des normes de chacun des courants de phase (∥I_{A}∥, ∥I_{B}∥, ∥I_{C}∥) sur une durée prédéterminée (T_{acq});
- l'interprétation des résultats du traitement des signaux, pour indiquer si le défaut détecté (D) se situe en aval ou en amont de l'endroit où les signaux représentatifs des normes des courants de phase (∥I_{A}∥, ∥I_{B}∥, ∥I_{C}∥) ont été obtenus, par une comparaison entre ladite moyenne (µ) et lesdits signaux représentatifs de la norme de chacun des courants de phase (∥I_{A}∥, ∥I_{B}∥, ∥I_{C}∥).

14. Procédé de détection directionnelle selon la revendication 13 dans lequel le signal (D) indicateur de la présence d'un défaut (10) est obtenu par la comparaison des signaux représentatifs des normes à une référence phase (∥I_{A}∥_{ref}, ∥I_{B}∥_{ref}, ∥I_{C}∥_{ref}).

15. Procédé de protection d'une ligne de courant (4) lors de l'apparition d'un défaut (10) comprenant l'actionnement d'un dispositif de coupure (5) de ladite ligne (4) si un défaut (10) a été détecté par un procédé selon l'une des revendications 11 à 14 à l'aval dudit dispositif de coupure (6).

## Patentansprüche

1. Analysevorrichtung (15), die in einem Dreiphasennetz (1) mit einer Eigenfrequenz (F) verwendet wird, umfassend:
- erste Mittel (20), um Parameter zu liefern, die für die Ströme (I_{X}) jeder der Phasen repräsentativ sind, umfassend Empfangsmittel (22) von Signalen, die für die Ströme jeder der Phasen repräsentativ sind, wobei Einweggleichrichtermittel (28) der Signale erste Parameter (I_{Xp}) liefern;
- zweite Mittel (30) zur Bearbeitung der repräsentativen Parameter, umfassend Berechnungsmittel (44) des Stroms, der sich aus der Summe (I₀ₚ) der ersten Parameter (I_{Xp}) und der Frequenzanalysemittel (46, 48) des Resultats (I₀ₚ) ergibt;
**dadurch gekennzeichnet, dass**:
- die Frequenzanalysemittel (46, 48) der zweiten Bearbeitungsmittel (30) einen Vergleich der Komponenten einer Harmonischen Null (I_{0pDC}) und einer Harmonischen Zwei (I_{0p2F}) des Resultats (I₀ₚ) der Berechnungsmittel (44) im Vergleich mit der Eigenfrequenz (F) des Netzes (1) umfassen; und
- die Analysevorrichtung (15) für die Identifikation eines Defekts (10) in einem Dreiphasennetz (1) geeignet ist und ferner umfasst:
- Aktivierungsmittel (32) der zweiten Bearbeitungsmittel (30) in Abhängigkeit von einem Signal (D) zur Erfassung des Vorhandenseins eines Defekts (10) im Netz (1);
- Interpretationsmittel (40) der Resultate der Bearbeitung der ersten Parameter (I_{Xp}) durch die zweiten Mittel (30), um zu bestimmen, ob der Defekt (10) zweiphasig ist.

2. Identifikationsvorrichtung (15) nach Anspruch 1, bei der die Frequenzanalysemittel (46, 48) der zweiten Mittel (30) ferner einen Vergleich der Komponenten einer Harmonischen Null (I_{0pDC}) und einer Harmonischen Eins (I_{0pF}) des Resultats (I₀ₚ) aus der Summe der ersten Parameter (I_{Xp}) im Vergleich mit der Eigenfrequenz (F) des Netzes (1) umfassen, und bei der die Interpretationsmittel (40) der Resultate der Bearbeitung der ersten Parameter (I_{Xp}) geeignet sind zu bestimmen, ob der Defekt (10) einphasig ist.

3. Vorrichtung (15) zur Identifikation und direktionalen Erfassung eines Defekts (10) in einem Drehphasennetz (1) mit einer Eigenfrequenz (F), umfassend eine Identifikationsvorrichtung nach einem der Ansprüche 1 oder 2, bei der:
- die ersten Mittel (20) ferner Berechnungsmittel (26) einer Norm der Signale, die für die Ströme jeder Phase (I_{X}) repräsentativ sind, umfassen, die zweite Parameter (∥I_{X}∥) liefern;
- die zweiten Mittel (30) ferner Berechnungsmittel (36) des Durchschnitts (µ) der zweiten Parameter (∥I_{X}∥) über eine vorbestimmte Dauer (T_{acq}) und Vergleichsmittel (38) jeder der Normen (∥I_{X}∥) mit dem berechneten Durchschnitt (µ) umfassen;
- die Interpretationsmittel (40) geeignet sind, um das Resultat der Bearbeitung der zweiten Parameter (∥I_{X}∥) durch die zweiten Mittel (30) zu bearbeiten, um zu bestimmen, ob der Defekt stromaufwärts oder stromabwärts zu der Vorrichtung (15) liegt.

4. Vorrichtung zur Identifikation und direktionalen Erfassung (15) nach Anspruch 3, bei der die Frequenzanalysemittel (46, 38) der zweiten Mittel (30) ferner einen Vergleich der Harmonischen Null (I_{0pDC}) des Resultats (I₀ₚ) aus der Summe der ersten Parameter (I_{Xp}) mit einer Grenze umfassen, und bei der die Interpretationsmittel (40) der Resultate der Bearbeitung der ersten Parameter (I_{Xp}) durch die zweiten Mittel (30) geeignet sind, einen Dreiphasendefekt zu identifizieren und ihn stromaufwärts oder stromabwärts zu der Vorrichtung (15) zu lokalisieren.

5. Vorrichtung zur Identifikation und direktionalen Erfassung (15) nach einem der Ansprüche 3 oder 4, bei der die ersten Mittel (20) Stichprobenmittel (24) und Speichermittel (34) eines Referenzwerts (∥I_{X}∥₀) aus den Berechnungsmitteln der Norm (26) vor Defekt umfassen.

6. Vorrichtung zur Identifikation und direktionalen Erfassung (15) nach Anspruch 5, bei der die zweiten Mittel (30) Mittel (42) umfassen, um die zweiten Parameter (∥I_{X}∥) mit der Referenznorm (∥I_{X}∥₀) der Speichermittel (34) zu vergleichen, und die Interpretationsmittel (40) der Resultate der Bearbeitung der zweiten Parameter (∥I_{X}∥) geeignet sind, die Natur des Zweiphasendefekts (10) zu identifizieren.

7. Identifikationsvorrichtung (15) nach einem der Ansprüche 1 bis 6, ferner umfassend Mittel (32) zur Erfassung des Vorhandenseins eines Defekts vom Typ Kurzschluss (10) im Netz (1), die mit den Aktivierungsmitteln der Bearbeitungsmittel der Signale (30) verbunden sind.

8. Vorrichtung zur Identifikation und direktionalen Erfassung (15) nach Anspruch 6, bei der die zweiten Mittel (30) Speichermittel (34) eines Werts der zweiten Parameter (∥I_{X}∥_{ref}) umfassen, und ferner umfassend Mittel (32) zur Erfassung des Vorhandenseins eines Defekts vom Typ Kurzschluss (10) im Netz (1), die mit den Aktivierungsmitteln der Bearbeitungsmittel der Signale (30) und den Speichermitteln (34) verbunden sind, wobei die Erfassungsmittel (32) Mittel umfassen, um jeden der zweiten Parameter (∥I_{X}∥) mit dem gespeicherten Wert (∥I_{X}∥_{ref}) zu vergleichen.

9. Indikator eines Defektdurchgangs vom Typ Kurzschluss, umfassend Stromfühler (12_{A}, 12_{B}, 12_{C}), die auf jedem Phasenleiter (4_{A}, 4_{B}, 4c) eines zu überwachenden elektrischen Netzes (1) angeordnet sind, und umfassend eine Vorrichtung zur Identifikation eines Defekts (15) nach einem der Ansprüche 1 bis 8, die an die Stromfühler (12_{A}, 12_{B}, 12_{C}) angeschlossen ist, um die Signale, die für die Normen der Phasenströme (∥I_{X}∥) repräsentativ sind, zu empfangen.

10. Schutzerdungsrelais (8), umfassend mindestens einen Defektindikator nach Anspruch 9 und Mittel zur Betätigung einer Unterbrechungsvorrichtung (5) in Abhängigkeit von den Resultaten der Interpretationsmittel (40) der Identifikationsvorrichtung (15) des Indikators.

11. Verfahren zur Identifikation (N) eines Defekts (10) in einem Dreiphasennetz (1), umfassend die folgenden Schritte nacheinander:
- Auslösung nach Erhalt eines Signals (D), das das Vorhandensein des Defekts (10) anzeigt;
- Erhalt von Signalen, die für jeden der Phasenströme über eine Dauer (T_{acq}) von mindestens einer Halbperiode des Netzes repräsentativ sind;
- Einweggleichrichtung der für die Phasenströme (I_{A}, I_{B}, I_{C}) repräsentativen Signale;
- vektorielle Summierung (I₀ₚ) der gleichgerichteten Signale (I_{Ap}, I_{Bp}, I_{Cp});
- Frequenzanalyse der vektoriellen Summierung der gleichgerichteten Signale (I₀ₚ);
- Vergleich des Signals einer Harmonischen 2 (I_{0p2F}) mit dem Signal einer Harmonischen 0 (I_{0pDC}) der Frequenzanalyse.

12. Verfahren nach Anspruch 11, ferner umfassend einen Vergleich des Signals einer Harmonischen 1 (I_{0pF}) mit dem Signal einer Harmonischen 0 (I_{0pDC}) der Frequenzanalyse.

13. Verfahren zur Identifikation (N) und relativen Lokalisation (L) eines Defekts (10) in einem Dreiphasennetz (1), umfassend ein Identifikationsverfahren nach einem der Ansprüche 11 oder 12 und ferner umfassend:
- die Bestimmung einer Norm (∥I_{A}∥, ∥I_{B}∥, ∥I_{C}∥), die für den Strom jeder Phase repräsentativ ist;
- die Berechnung des arithmetischen Durchschnitts (µ) der Normen jedes der Phasenströme (∥I_{A}∥, ∥I_{B}∥, ∥I_{C}∥) über eine vorbestimmte Dauer (T_{acq});
- die Interpretation der Resultate der Bearbeitung der Signale, um anzuzeigen, ob der erfasste Defekt (D) stromabwärts oder stromaufwärts zu der Stelle liegt, wo die für die Normen der Phasenströme (∥I_{A}∥, ∥I_{B}∥, ∥I_{C}∥) repräsentativen Signale erhalten wurden, durch einen Vergleich zwischen dem Durchschnitt (µ) und den für die Norm jedes der Phasenströme (∥I_{A}∥, ∥I_{B}∥, ∥I_{C}∥) repräsentativen Signalen.

14. Verfahren zur direktionalen Erfassung nach Anspruch 13, bei dem das Signal (D), das das Vorhandensein eines Defekts (10) anzeigt, durch den Vergleich der für die Normen repräsentativen Signale mit einer Phasenreferenz (∥I_{A}∥_{ref}, ∥I_{B}∥_{ref}, ∥I_{C}∥_{ref}) erhalten wird.

15. Verfahren zum Schutz einer Stromleitung (4) beim Auftreten eines Defekts (10), umfassend die Betätigung einer Unterbrechungsvorrichtung (5) der Leitung (4), wenn ein Defekt (10) durch ein Verfahren nach einem der Ansprüche 11 bis 14 stromabwärts zu der Unterbrechungsvorrichtung (6) erfasst wurde.

## Claims

1. An analysis device (15) used in a three-phase power system (1) having a natural frequency (F) comprising:
- first means (20) for providing parameters representative of the currents (I_{X}) of each of the phases comprising means for receiving (22) signals representative of the currents of each of the phases, half-wave rectifying means (28) of said signals providing first parameters (I_{Xp});
- second processing means (30) of the representative parameters comprising means for calculating (44) the current resulting from the sum (I₀ₚ) of the first parameters (I_{Xp}) and frequency analysis means (46, 48) of said result (I₀ₚ);
**characterized in that**:
the frequency analaysis means (46, 48) of the second processing means (30) comprise comparison of the zeroth harmonic component (I_{0p DC}) and second harmonic component (I_{0p 2F}) of the result (I₀ₚ) of the calculations means (44) with the natural frequency (F) of the power system (1); and
- said analysis device (15) is adapted for identification of a fault (10) in a three-phase power system (1), and for then comprises:
- activation means (32) of said second processing means (30) according to a detection signal (D) of the occurrence of a fault (10) in the power system (1); and
- interpretation means (40) of the results of the processing by the second means (30) of the first parameters (I_{Xp}) to determine whether the fault (10) is two-phase.

2. The device (15) for identification according to claim 1 wherein the analysis means (46, 48) of the second means (30) further comprise comparison of the zeroth harmonic component (I_{0p DC}) and first harmonic component (I_{0p F}) with the natural frequency (F) of the power system (1) of the result (I₀ₚ) provided by the sum of the first parameters (I_{Xp}), and wherein the interpretation means (40) of the results of processing of the first parameters (I_{Xp}) are able to determine whether the fault (10) is single-phase.

3. A device (15) for identification and directional detection of a fault (10) in a power system three-phase (1) having a natural frequency (F) comprising an identification device according to one of claims 1 or 2 wherein:
- the first means (20) further comprise means for calculating (26) a norm of the signals representative of the currents of each phase (I_{X}) providing second parameters (∥I_{X}∥);
- the second means (30) further comprise means for calculating (36) the mean (µ) of the second parameters (∥I_{X}∥) over a predefined time (T_{acq}) and means for comparing (38) each of the norms (∥I_{X}∥) with said calculated mean (µ);
- the interpretation means (40) are designed to process the result of processing by the second means (30) of the second parameters (∥I_{X}∥) to determine whether the fault is located line-side or load-side of the device (15).

4. The device for identification and directional detection (15) according to claim 3 wherein the frequency analysis means (46, 48) of the second means (30) further comprise comparison of the zeroth harmonic (I_{0p DC}) of the result (I₀ₚ) provided by the sum of the first parameters (I_{Xp}) with a threshold, and wherein the interpretation means (40) of the results of the processing by the second means (30) of the first parameters (I_{Xp}) are able to identify a three-phase fault and to locate the latter line-side or load-side of the device (15).

5. The device for identification and directional detection (15) according to one of claims 3 or 4 wherein the first means (20) comprise sampling means (24) and storage means (34) of a reference value (∥I_{X}∥₀) provided by means for calculating the norm (26) before a fault.

6. The device for identification and directional detection (15) according to claim 5 wherein the second means (30) comprise means (42) for comparing the second parameters (∥I_{X}∥) with the reference norm (∥I_{X}∥₀) of the storage means (34), and the interpretation means (40) of the results of processing of the second parameters (∥I_{X}∥) are able to identify the nature of the two-phase fault (10).

7. The identification device (15) according to one of claims 1 to 6 further comprising means (32) for detecting the occurrence of a short-circuit fault (10) in the power system (1) connected to the activation means of the signal processing means (30).

8. The device (15) for identification and directional detection (15) according to claim 6 wherein the second means (30) comprise storage means (34) of a value of the second parameters (∥I_{X}∥_{ref}) and further comprising means (32) for detecting the occurrence of a short-circuit fault (10) in the power system (1) connected to the activation means of the signal processing means (30) and to the storage means (34), said means (32) for detecting comprising means for comparing each of the second parameters (∥I_{X}∥) with the stored value (∥I_{X}∥_{ref}).

9. A short-circuit fault flow indicator comprising current sensors (12_{A}, 12_{B}, 12_{C}) arranged on each phase conductor (4_{A}, 4_{B}, 4_{C}) of an electric power system (1) to be monitored and comprising a fault identification device (15) according to one of claims 1 to 8 connected to said current sensors (12_{A}, 12_{B}, 12_{C}) to receive the signals representative of the norms of the phase currents (∥I_{X}∥).

10. An earth protection relay (8) comprising at least one fault indicator according to claim 9 and means for actuating a switchgear device (5) according to the results of the interpretation means (40) of the identification device (15) of the indicator.

11. A method for identifying (N) a fault (10) in a three-phase power system (1) comprising the successive steps of:
- triggering following a signal (D) being obtained indicating the presence of said fault (10);
- acquiring signals representative of each of the phase currents over a time (T_{acq}) of at least one half-period of the power system;
- half-wave rectification of the signals representative of the phase currents (I_{A}, I_{B}, I_{C});
- vector summing (I₀ₚ) of the rectified signals (I_{Ap}, I_{Bp}, I_{Cp});
- frequency analysis of the vector summing of the rectified signals (I₀ₚ);
- comparison of the second harmonic signal (I_{0p 2F}) with the zeroth harmonic signal (I_{0p DC}) of the frequency analysis.

12. The method according to claim 11 further comprising comparison of the first harmonic signal (I_{0p F}) with the zeroth harmonic signal (I_{0p DC}) of the frequency analysis.

13. A method for identification (N) and relative location (L) of a fault (10) in a three-phase power system (1) comprising a method for identifying according to one of claims 11 or 12 and further comprising:
- determination of a norm (∥I_{A}∥, ∥I_{B}∥, ∥I_{C}∥) representative of the current of each phase;
- calculation of the arithmetic mean (µ) of the norms of each of the phase currents (∥I_{A}∥, ∥I_{B}∥, ∥I_{C}∥) over a predefined time (T_{acq});
- interpretation of the results of processing of the signals to indicate whether the detected fault (D) is located load-side or line-side of the place where the signals representative of the norms of the phase currents (∥I_{A}∥, ∥I_{B}∥, ∥I_{C}∥) were obtained, by comparison between said mean (µ) and said signals representative of the norm of each of the phase currents (∥I_{A}∥, ∥I_{B}∥, ∥I_{C}∥).

14. The method for directional detection according to claim 13 wherein the signal (D) indicating the presence of a fault (10) is obtained by comparison of the signals representative of the norms with a phase reference (∥I_{A}∥_{ref}, ∥I_{B}∥_{ref}, ∥I_{C}∥_{ref}).

15. A method for protecting a current line (4) when a fault (10) occurs comprising actuation of a switchgear device (5) of said line (4) if a fault (10) has been detected by a method according to one of claims 11 to 14 load-side of said switchgear device (6).
